Europäisches Patentamt

European Patent Office

Office européen des brevets

(11) Publication number: **0 225 374**
**B1**

(12) **EUROPEAN PATENT SPECIFICATION**

(45) Date of publication of patent specification: **29.08.90**

(21) Application number: **86903815.8**

(22) Date of filing: **13.05.86**

(86) International application number:
**PCT/US86/01046**

(87) International publication number:
**WO 86/07492 18.12.86 Gazette 86/27**

(51) Int. Cl.⁵: **H 01 L 21/48**

(54) **LEAD FRAME DEFLASHING.**

(30) Priority: **11.06.85 US 743667**

(43) Date of publication of application:
**16.06.87 Bulletin 87/25**

(45) Publication of the grant of the patent:
**29.08.90 Bulletin 90/35**

(84) Designated Contracting States:
**AT BE CH DE FR GB IT LI NL SE**

(56) References cited:
**EP-A-0 019 186**
**EP-A-0 084 424**
**EP-A-0 098 176**

(73) Proprietor: **AMERICAN TELEPHONE AND TELEGRAPH COMPANY**
**550 Madison Avenue**
**New York, NY 10022 (US)**

(72) Inventor: **MOYER, Harold, William**
**1602 Ruth Street**
**Allentown, PA 18104 (US)**
Inventor: **SCHOLZ, Harry, Robert**
**1385 Oak Drive**
**Macungie, PA 18062 (US)**

(74) Representative: **Johnston, Kenneth Graham et al**
**AT&T (UK) LTD. AT&T Intellectual Property Division 5 Mornington Road**
**Woodford Green Essex, IG8 OTU (GB)**

Courier Press, Leamington Spa, England.

## Description

### Background of the invention

The standard post-molded plastic integrated circuit package starts with a metal lead frame to which the semiconductor integrated circuit is bonded and a plastic housing or encapsulant is molded around the semiconductor body. Lead frame fingers extend from two opposite sides of the molded plastic body in a dual-in-line arrangement or from all four sides in a so-called quad pack.

A problem with such packages is that encapsulent material frequently occurs in unwanted places, e.g., between and on the leads. This material is removed in a subsequent "deflashing" step. Known processes for doing this, however, tend to be expensive and occasionally destructive of the devices being deflashed. From EP—A—0 084 424 a chemical removal of resin bleed from encapsulated devices in known in which the lead frame is subjected to chemical treatment by applying to the device a material which is a solvent of the encapsulating resin for a time sufficient to remove the resin bleed but insufficient to cause damage to the resin encapsulation. The present invention such as claimed relates to an improved deflashing technique.

### Statement of the invention

The encapsulent material (e.g., plastic) residing between the lead frame fingers and on top of them is removed using a laser. Although laser machining is a widely practiced expedient, and there exists a well recognized need for new deflashing approaches, no one has recognized or discovered the key elements to this combination. Among these are the demonstration that the laser can be made to scan the entire field externally of the encapsulated body, without causing damage to the leads extending from the body. Stated another way, we have discovered that a laser beam, powerful enough to remove waste plastic material from and between leads in a standard lead frame package, and powerful enough to effect this removal in an economically acceptable time frame, is self selective, i.e. the proportion of laser energy deposited on the waste plastic with respect to the proportion deposited on the fragile leads is very high, sufficiently high that the plastic may be evaporated or vaporized away without damage to the surface of the leads. We have demonstrated that this can be achieved with economical throughput. We have also demonstrated that the waste plastic encapsulant can be removed without residue that would impair the electrical performance of the device or affect its subsequent attachment during a solder reflow operation. The removal of plastic by vaporization is a process of combustion that would be expected to produce carbon or a carbonaceous residue. Such a residue would be electrically conductive and would cause shorts or electrical leaks in an electrical package of this nature. We have demonstrated that this does not occur. Also, it is significant technologically that our deflashing techniques leaves the electrical leads in a pristine state. In fact, the leads are cleaner than prior to the deflashing operation. Residue and oxides that form on the leads during previous processing, or during the molding operation, are removed effectively at the same time the waste molding material is removed. This advantage flows from the important recognition noted earlier that the laser beam used for deflashing does not have to be programmed for selective incidence on the interlead space but is non-selectively scanned over the leads as well as the space between leads. The resulting deflashed devices may be solder coated or packaged without further cleaning. The elimination of the cleaning and/or rinsing operations that are required with abrasive or solvent deflashing is a significant economic benefit.

Having recognized that the high power machining laser beam may be incident on the leads without adverse consequences, and potentially with benefits, it will be recognized that laser beams with apertures larger than the interlead spacing may be used, thus increasing the throughput of the process.

### Brief description of the drawings

Fig. 1 is a perspective view of a fine pitch quad package typical of the kind to which the invention is applicable;

Fig. 2 is a plan view of that package after molding;

Fig. 3 is a side view through section 3—3 of Fig. 2;

Fig. 4 is a schematic representation of possible scanning patterns for a laser in removing the waste material shown in Figs. 2—4;

Fig. 5 is a plan view of the package after deflashing;

Fig. 6 is a plan view of a lead frame with the dam bar eliminated.

### Detailed description

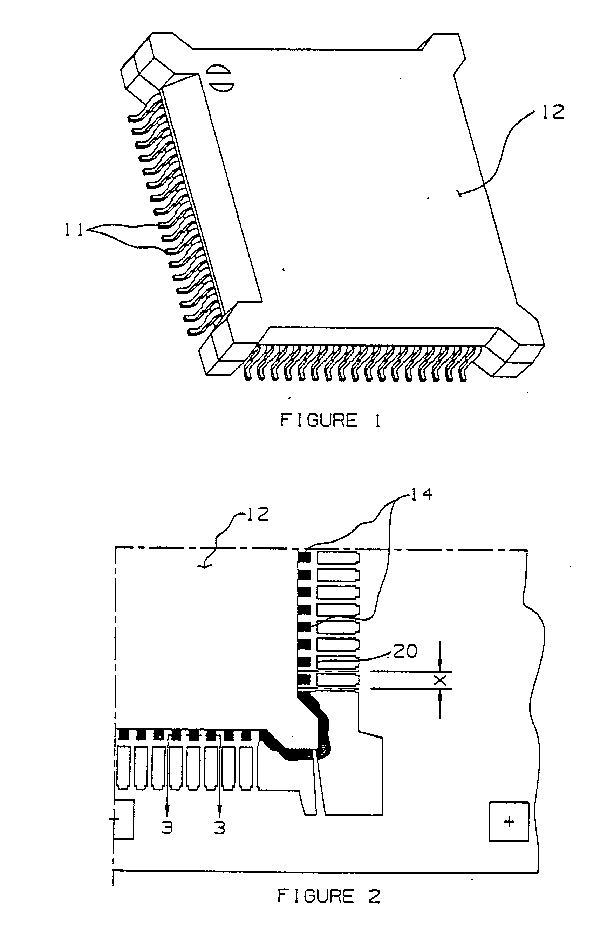

With reference to Fig. 1, a fine pitch quad pack integrated circuit package is shown having 17 leads per side extending from the encapsulated semiconductor device 12. The center-to-center spacing of the leads, i.e. the "pitch" of the leads, is shown as dimension "x" in Fig. 2. With a constant overall package size, as the number of leads along any side of the package is increased, the pitch of the leads decreases. It will be evident intuitively that residual or waste material 14 (Fig. 2) left over from the molding operation becomes more difficult to remove as the pitch decreases. Mold chases containing "hibbles", i.e. protrusions in the mold designed to fit between lead frame fingers and prevent molding compound from exuding between the leads as shown, cannot be used effectively for small pitch packages because the fit of the mold to the lead frame in a production environment cannot be assured. Instead, a dam bar like that shown at 20 in Fig. 2 is used to limit the extent to which molding material 14 exits the mold in the region between the leads.

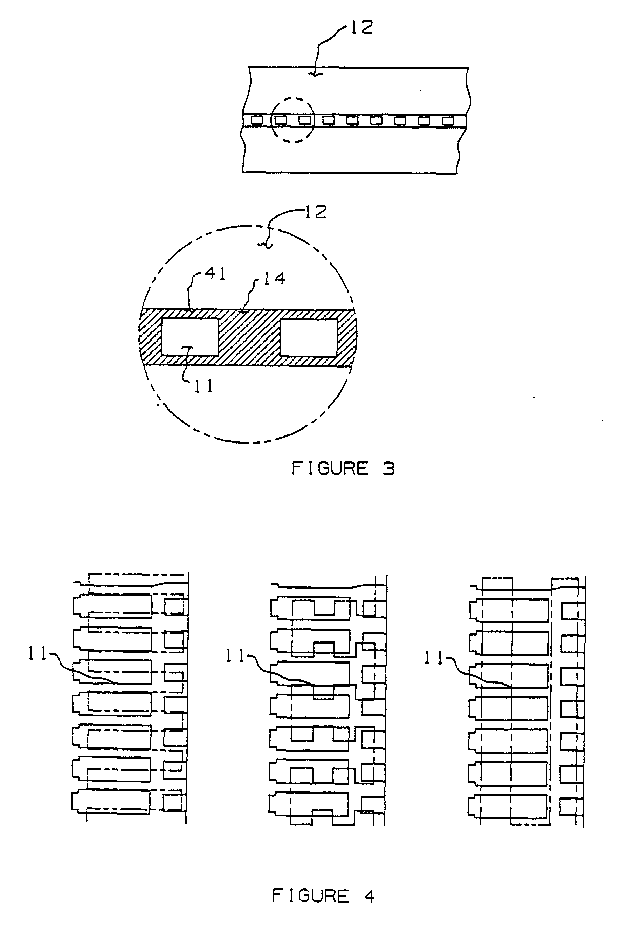

Residual molding compound 14 remains between the leads as shown in Fig. 2. Residual or unwanted molding compound 41 also occurs on the surface of the leads as shown in the sectional view of Fig. 3. This results from one or more of incomplete closing of the mold, imprecise mold machining, or imprecise alignment or control of the dimensions of the leads. All of the unwanted molding material is removed according to the invention by scanning the leads as well as the space between the leads with a laser at an appropriate wavelength, power level, scanning speed, and Q-switching rate. These parameters will vary substantially depending upon the device package design, the molding material the lead frame finish, and other considerations of choice. An exemplary set of parameters that will allow the practice of the invention in one form is given below. The pattern used to scan the leads may also vary considerably. Examples of scanning patterns that are useful are shown in Fig. 4.

With reference to Fig. 3, it can be appreciated that the requirements of the laser in deflashing the part 12 without damage are severe. The laser must remove the plastic material 14 and the material 41 without damage to the leads 11. This, in spite of the fact that the thickness of the unwanted material 14 between the leads may be tenfold or more than the thickness of the unwanted material 41 on the leads. Thus the full laser power will be incident on the bare surface of the lead during most of the operation, and during all of the operation when no residue 41 occurs.

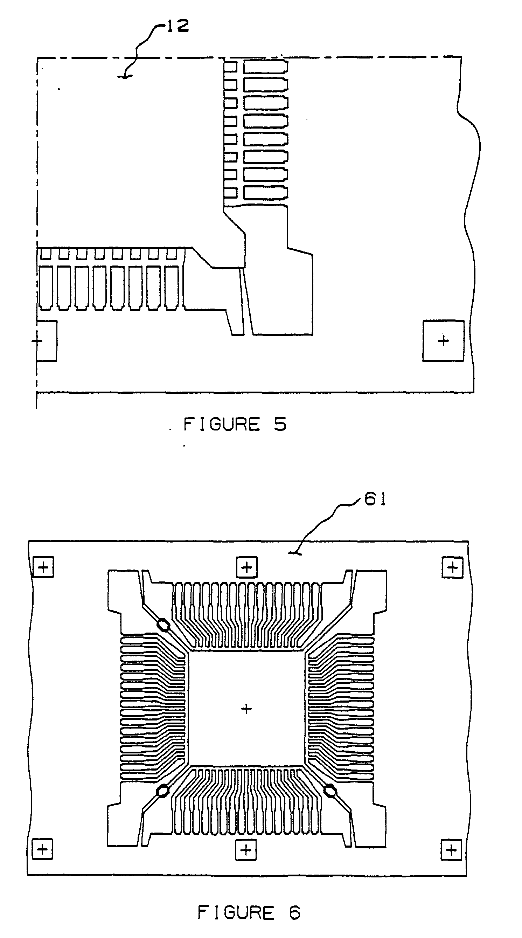

The finished deflashed part is shown in Fig. 5.

A lead frame with the dam bar omitted is shown in Fig. 6. With the use of this invention, removal of waste molding material from the space between lead frame fingers is so effective that the dam bar can be eliminated from the lead frame. The molding material is allowed to exude to the outer frame 61. The eliminates the punching operation normally required for removing the dam bar after the molding operation.

The efficacy of the invention was demonstrated on commercial devices with outstanding results. The laser used was a Nd:YAG laser operating at 1.064 nm, capable of 50w continuous wave output, and available as model 512 from Control Laser Corp.

To determine the flexibility of the laser approach, three different types of parts were processed:

(1) Forty-pin, 100-mil pitch, Dual-In-Line Packages on a 10-mil copper lead frame with dam bars, a nickel finish, and molded using Hysol MG30F molding compound.

(2) Sixty-eight-pin, 25-mil pitch, Quad packages on a 6-mil copper lead frame without dam bars, a nickel/gold finish, and molded using Plaskon 3200LS molding compound in a mold containing "hibbles".

(3) Forty-pin, 25-mil pitch, Quad packages on a 6-mil copper lead without dam bars, a nickel/gold finish, and molded using Plaskon 3200LS molding compound in a mold without "hibbles".

All of the packages were deflashed using the same lamp current and output power. The acousto-optical Q-switching rate was fixed at 3.0, 2.25, and 1.75 kHz per side for previously described package types (1), (2), and (3), respectively. The ability of almost identical beam profiles to handle large variations in "flash" thickness, width, and varying degrees of lamination was evident from the samples processed. When this observation is coupled with the fact that the beam has a 0.040" depth of field, the impact of this technique on manufacturing is impressive. This forgiving process is extremely tolerant of the sample height and the amount of flash present, implying that laser parameters will not have to be reset for relatively large variations in flashing conditions.

Experiments were performed on parts deflashed following the procedures just outlined to measure lead-to-lead current leakage. An electrometer with a sensitivity range extending to $10^{-15}$ amperes was used to make the measurement. Leakage levels of less than $1 \times 10^{-12}$ amperes were found.

Experiments were also performed using Auger spectroscopy to measure residual carbon on the leads after deflashing. Excessive carbon residue might be expected from the vaporization of the molding compound and this excessive residue would be expected to prevent solder reflow on the electrical leads. Excessive residue on the leads would also indicate the presence of residue on the package sidewalls that would produce undesirable leakage. The latter was already measured and not found. The Auger measurements revealed carbon levels no greater than those encountered after conventional molding-deflashing operations. Solder reflow experiments demonstrated complete lead coverage and demonstrated that no harmful residue remains on the leads after the laser deflashing operation.

## Claims

1. Technique for deflashing a molded integrated circuit package said package comprising a molded central body encapsulating the semiconductor device, and a plurality of electrical leads extending away from the central body, and including in addition residual waste molding material external of the central body and between the electrical leads, the deflashing operation characterized by the step of exposing the said residual waste molding material to a scanning laser beam at an appropriate wavelength, power level, scanning speed and Q-switching rate, in such a way that the scanning beam is non-selectively incident on both the waste molding material and one or more surfaces of the electrical leads to remove the residual waste molding material without impairing the electrical leads.

2. The technique of claim 1 in which residual waste molding material covers portions of the surface of the electrical leads as well as the space therebetween and the scanning laser removes all the residual waste material on which it is incident.

3. The technique of claim 1 in which the laser is a Nd:YAG laser.

**Patentansprüche**

1. Verfahren zum Entgraten eines umgossenen integrierten Schaltungs-Bauteils, das einen umgossenen zentralen Körper aufweist, der die Halbleitervorrichtung einkapselt und eine Mehrzahl von elektrischen Leitungen besitzt, die von dem zentralen Körper wegstreben, wobei zusätzlich restliches Überschußgießmaterial außerhalb des zentralen Körpers und zwischen den elektrischen Leitungen vorhanden ist, gekennzeichnet, durch folgenden Entgratungsschritt: das restliche Überschußgießmaterial wird einem abtastenden Laserstrahl bei geeigneter Wellenlänge, Energieniveau, Abtastgeschwindigkeit und Q-Schaltrate in solcher Weise zugeführt, daß der Abtaststrahl in nichtselektiver Weise sowohl auf das Überschußgießmaterial als auch auf eine oder mehrere Oberflächen der elektrischen Leitungen auftrifft, um das restliche Überschußgießmaterial ohne Gefährdung der elektrischen Leitungen zu entfernen.

2. Verfahren nach Anspruch 1, dadurch gekennzeichnet, daß das restliche Überschußgießmaterial Teile der Oberfläche der elektrischen Leitungen sowie deren Zwischenraum bedeckt und daß der abtastende Laser das gesamte restliche Überschußgießmaterial entfernt, auf das er auftrifft.

3. Verfahren nach Anspruch 1, bei dem der Laser aus einem Nd:YAG-Laser besteht.

**Revendications**

1. Technique pour ébavurer un boîtier de circuit intégré moulé, ce boîtier comprenant un bloc central moulé qui encapsule de dispositif à semiconducteurs, et un ensemble de conducteurs électriques qui s'étendent à partir du bloc central, et comprenant en outre du matériau de moulage résiduel en excès à l'extérieur du bloc central et entre les conducteurs électriques, l'opération d'ébavurage étant caracterisée par l'étape qui consiste à exposer le matériau de moulage résiduel en excès à l'action d'un faisceau laser effectuant un mouvement de balayage, ce faisceau ayant des valeurs appropriées de longueur d'onde, de niveau de puissance, de vitesse de balayage et de cadence de déclenchement (laser fonctionnant en mode déclenché), d'une manière telle que le faisceau effectuant un mouvement de balayage tombe de façon non sélective à la fois sur le matériau de moulage en excès et sur une ou plusieurs surfaces des conducteurs électriques, pour enlever le matériau de moulage résiduel en excès sans endommager les conducteurs électriques.

2. La technique de la revendication 1, dans laquelle le matériau de moulage résiduel en excès couvre des parties de la surface des conducteurs électriques, ainsi que l'espace entre eux, et le faisceau laser effectuant un mouvement de balayage enlève la totalité du matériau résiduel en excès sur lequel il tombe.

3. La technique de la revendication 1, dans laquelle le laser est un laser Nd/YAG.

FIGURE  1

FIGURE  2

1

FIGURE 3

FIGURE 4

2

FIGURE 5

FIGURE 6